(19) Europäisches Patentamt / European Patent Office / Office européen des brevets

(11) **EP 4 391 373 B1**

(12) **EUROPEAN PATENT SPECIFICATION**

(45) Date of publication and mention
of the grant of the patent:
**04.03.2026 Bulletin 2026/10**

(21) Application number: **22874685.5**

(22) Date of filing: **19.09.2022**

(51) International Patent Classification (IPC):
*H03F 1/32* (2006.01)     *H03F 3/193* (2006.01)
*H03F 3/21* (2006.01)     *H03F 3/45* (2006.01)
*H03F 3/24* (2006.01)     *H03F 1/14* (2006.01)
*H03F 1/22* (2006.01)     *H03F 1/34* (2006.01)
*H03F 1/56* (2006.01)     *H03F 3/195* (2006.01)

(52) Cooperative Patent Classification (CPC):
**H03F 3/245; H03F 1/14; H03F 1/223; H03F 1/3205;**
**H03F 1/342; H03F 1/565; H03F 3/195; H03F 3/211;**
**H03F 3/45179;** H03F 2200/06; H03F 2200/09;
H03F 2200/222; H03F 2200/378; H03F 2200/387;
H03F 2200/42;                         (Cont.)

(86) International application number:
**PCT/CN2022/119557**

(87) International publication number:
**WO 2023/051298 (06.04.2023 Gazette 2023/14)**

(54) **POWER AMPLIFICATION CIRCUIT, POWER AMPLIFIER, AND TRANSMITTER**

LEISTUNGSVERSTÄRKERSCHALTUNG, LEISTUNGSVERSTÄRKER UND SENDER

CIRCUIT D'AMPLIFICATION DE PUISSANCE, AMPLIFICATEUR DE PUISSANCE ET ÉMETTEUR

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.09.2021 CN 202111163809**

(43) Date of publication of application:
**26.06.2024 Bulletin 2024/26**

(73) Proprietor: **Huawei Technologies Co., Ltd.**
**Shenzhen, Guangdong 518129 (CN)**

(72) Inventors:
• **REN, Zhixiong**
**Shenzhen, Guangdong 518129 (CN)**
• **LV, Yuyan**
**Shaanxi 710049 (CN)**
• **GUI, Xiaoyan**
**Shaanxi 710049 (CN)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
CN-A- 104 124 924     CN-A- 105 119 575
CN-U- 201 976 072     JP-A- 2012 029 201
US-A1- 2010 001 800   US-A1- 2016 156 315

• HENG ZHANG ET AL: "Linearization Techniques
for CMOS Low Noise Amplifiers: A Tutorial",
IEEE TRANSACTIONS ON CIRCUITS AND
SYSTEMS I: REGULAR PAPERS, IEEE, US, vol.
58, no. 1, 1 January 2011 (2011-01-01), pages 22 -
36, XP011340986, ISSN: 1549-8328, DOI: 10.1109/
TCSI.2010.2055353

- CHAO LU ET AL: "Linearization of CMOS Broadband Power Amplifiers Through Combined Multigated Transistors and Capacitance Compensation", IEEE TRANSACTIONS ON MICROWAVE THEORY AND TECHNIQUES, IEEE, USA, vol. 55, no. 11, 1 November 2007 (2007-11-01), pages 2320 - 2328, XP011195395, ISSN: 0018-9480, DOI: 10.1109/TMTT.2007.909142
- KAO KUN-YAO ET AL: "A 20 GHz power amplifier with IM3 distortion cancellation by load-split derivative superposition", 2016 IEEE MTT-S INTERNATIONAL MICROWAVE SYMPOSIUM (IMS), IEEE, 22 May 2016 (2016-05-22), pages 1 - 4, XP032941159, DOI: 10.1109/ MWSYM.2016.7540135
- JOGLEKAR SAMEER ET AL: "Large signal linearity enhancement of AlGaN/GaN high electron mobility transistors by device-level Vt engineering for transconductance compensation", 2017 IEEE INTERNATIONAL ELECTRON DEVICES MEETING (IEDM), IEEE, 2 December 2017 (2017-12-02), XP033306039, DOI: 10.1109/IEDM.2017.8268457

(52) Cooperative Patent Classification (CPC): (Cont.)
    H03F 2200/537; H03F 2200/54; H03F 2200/75;
    H03F 2203/45712; Y02D 30/70

## Description

## TECHNICAL FIELD

This application relates to the field of electronic technologies, and in particular, to a power amplification circuit, a power amplifier, and a transmitter.

## BACKGROUND

Complementary metal oxide semiconductors (Complementary Metal Oxide Semiconductor, CMOS), as a mainstream semiconductor technology, are widely used for implementations of various digital/analog signal processing chips, such as common communication basebands and analog transceivers. A power amplifier (Power Amplifier, PA) serves as a last-stage module of a transmitter. PAs developed based on the CMOS technology are mainly used in narrowband low-power scenarios such as Bluetooth, Zigbee, and NB-IoT, and may also be used in early Wi-Fi systems. However, with an increase in quadrature amplitude modulation (Quadrature Amplitude Modulation, QAM) orders of modulated signals, to ensure lossless transmission of the signals, a requirement on signal-to-noise ratios of communication links also increases accordingly. Therefore, sending of high-order QAM signals requires the PA to have higher linearity, for example, lower amplitude modulation-amplitude modulation (Amplitude Modulation-Amplitude Modulation, AM-AM) distortion and lower amplitude modulation-phase modulation (Amplitude Modulation-Phase Modulation, AM-PM) distortion. Therefore, how to design a high-linearity PA to meet transmission of high-bandwidth and high-order QAM signals is a technical problem that needs to be urgently resolved by a person skilled in the art.

HENG ZHANG ET AL: "Linearization Techniques for CMOS Low Noise Amplifiers: A Tutorial", IEEE TRANSACTIONS ON CIRCUITS AND SYSTEMS I: REGULAR PAPERS, IEEE, US, vol. 58, no. 1, 1 January 2011, pages 22-36, ISSN: 1549-8328, DOI: 10.1109/TCSI.2010.2055353 discloses CMOS LNA-linearization techniques and discussed the tradeoffs among linearity, power, and PVT variations. Further, the document discusses wide-band-LNA-linearization issues for the emerging broadband transceivers, noting that IIP2 is becoming just as important as IIP3, and that improving P; ag is also necessary for wide-band applications to improve high-signal-handling capability. Issues in DSM processes, such as nonlinear output conduc-tance were examined. A key challenge resides in delivering high linearity with core transistors and low supply voltage in the DSM processes. Finally, general design guidelines for high-linearity LNAs are presented.

CN 104 124 924 A discloses a linearization common-gate CMOS low-noise amplifier circuit which is of a differential symmetrical structure and comprises an input stage, a cascading stage and a distortion eliminating stage. A radio frequency differential signal is inputted from the input stage, an amplified differential output signal is outputted from the cascading stage, the distortion eliminating stage is connected to the cascading stage, and a PMOS transistor working in a weak inversion area is formed. The linearization common-gate CMOS low-noise amplifier circuit has the advantages that the linearity of LNA can be obviously improved, and meanwhile the performance of being high in gain and low in noise can be achieved.

## SUMMARY

The application provides a power amplifier of claim 1, and a transmitter of claim 11, to provide a high-linearity power amplification circuit. Further embodiments are disclosed in the dependent claims

According to a first aspect, a power amplification circuit being part of the power amplifier is disclosed. The power amplification circuit includs a power amplification unit and a compensation unit, where the power amplification unit may include a first MOS field effect transistor, a gate electrode of the first MOS field effect transistor is connected to an input signal end of the power amplification circuit, a drain electrode of the first MOS field effect transistor is connected to an output signal end of the power amplification circuit, and a source electrode of the first MOS field effect transistor is grounded. The compensation unit may include a third MOS field effect transistor, where a gate electrode of the third MOS field effect transistor is connected to a first bias voltage end, a source electrode of the third MOS field effect transistor is connected to the output signal end of the power amplification circuit, and a drain electrode of the third MOS field effect transistor is connected to a second bias voltage end. The first MOS field effect transistor is an N-type MOS field effect transistor, and the third MOS field effect transistor is a P-type MOS field effect transistor; or the first MOS field effect transistor is a P-type MOS field effect transistor, and the third MOS field effect transistor M3 is an N-type MOS field effect transistor.

According to the power amplification circuit provided in this embodiment of this application, the source electrode of the third MOS field effect transistor is connected to the drain electrode of the first MOS field effect transistor, and a conductivity type of the third MOS field effect transistor is opposite to a conductivity type of the first MOS field effect transistor M1. Therefore, a change trend of a gate-source capacitor Cgs of the third MOS field effect transistor with an input voltage is opposite to a change trend of a gate-drain capacitor Cgd of the first MOS field effect transistor with the input voltage, to enable the gate-drain capacitor of the first MOS field effect transistor basically not to change with the input voltage after compensation, thereby compensating AM-PM and improving linearity of the power amplification circuit. In addition, a design of the power amplification circuit is simple.

In an embodiment, a voltage of the first bias voltage end may be set between 0 and Vdd, where Vdd is a power supply voltage, and the second bias voltage end may be set to a virtual ground, that is, the second bias voltage end is grounded through a capacitor.

For example, in the power amplification circuit, the power amplification unit may further include a second MOS field effect transistor and a first bias sub-circuit. A gate electrode of the second MOS field effect transistor is connected to the input signal end of the power amplification circuit through the first bias sub-circuit, a drain electrode of the second MOS field effect transistor is connected to the output signal end of the power amplification circuit, and a source electrode of the second MOS field effect transistor is grounded. The first bias sub-circuit is configured to control a gate bias voltage of the second MOS field effect transistor. A direct current working point of the first MOS field effect transistor is biased to a class C, and a direct current working point of the second MOS field effect transistor is biased to a class AB; or a direct current working point of the first MOS field effect transistor is biased to a class AB, and a direct current working point of the second MOS field effect transistor is biased to a class C.

The first MOS field effect transistor and the second MOS field effect transistor have a same conductivity type, that is, both the first MOS field effect transistor and the second MOS field effect transistor are N-type MOS field effect transistors or P-type MOS field effect transistors.

In this application, the first MOS field effect transistor and the second MOS field effect transistor that are combined by using a multigate transistor technology are used for the power amplification unit. A direct current working point of one MOS field effect transistor is biased to the class AB, so that third-order nonlinear $gm''$ of transconductance $gm$ of the MOS field effect transistor is negative, and a direct current working point of the other MOS field effect transistor is biased to the class C, so that third-order nonlinear $gm''$ of transconductance $gm$ of the other MOS field effect transistor is positive. In this way, the third-order nonlinear $gm''$ of the transconductance $gm$ of the two MOS field effect transistors may be counteracted, to compensate AM-AM of the power amplification circuit, and improve a P1dB compression point of the power amplification circuit.

For example, the first bias sub-circuit may include a first capacitor and a first resistor. A first end of the first capacitor is connected to the input signal end of the power amplification circuit, and a second end of the first capacitor is connected to the gate electrode of the second MOS field effect transistor. A first end of the first resistor is connected to the gate electrode of the second MOS field effect transistor, and a second end of the first resistor is connected to a third bias voltage end. Therefore, the first resistor is used to control the gate bias voltage of the second MOS field effect transistor, the first capacitor may be used to isolate the gate electrode of the first MOS field effect transistor from the gate electrode of the second MOS field effect transistor, and the first capacitor may further play a role of blocking a direct current and conducting an alternating current.

During specific implementation, a voltage of the third bias voltage end may be designed based on a working status of the second MOS field effect transistor. An example in which the second MOS field effect transistor is an N-type MOS field effect transistor is used. When a direct current working point of the second MOS field effect transistor is biased to the class C, the voltage of the third bias voltage end may be less than a threshold voltage of the second MOS field effect transistor. When a direct current working point of the second MOS field effect transistor is biased to the class AB, the voltage of the third bias voltage end may be greater than a threshold voltage of the second MOS field effect transistor.

For example, in the power amplification circuit, the power amplification unit may further include a second bias sub-circuit connected between the input signal end of the power amplification circuit and the gate electrode of the first MOS field effect transistor; and the second bias sub-circuit is configured to control a gate bias voltage of the first MOS field effect transistor. Therefore, during actual application, when the input signal end of the power amplification circuit is connected to a transformer, the transformer is not required to control the gate bias voltage of the first MOS field effect transistor, and a common four-port transformer is used, to reduce design complexity.

For example, the second bias sub-circuit may include a second capacitor and a second resistor. A first end of the second capacitor is connected to the input signal end of the power amplification circuit, and a second end of the second capacitor is connected to the gate electrode of the first MOS field effect transistor. A first end of the second resistor is connected to the gate electrode of the first MOS field effect transistor, and a second end of the second resistor is connected to a fourth bias voltage end. Therefore, the second resistor is used to control the gate bias voltage of the first MOS field effect transistor, the second capacitor may be used to isolate the gate electrode of the first MOS field effect transistor from the gate electrode of the second MOS field effect transistor, and the second capacitor may further play a role of blocking a direct current and conducting an alternating current.

During specific implementation, a voltage of the fourth bias voltage end may be designed based on a working status of the first MOS field effect transistor. An example in which the first MOS field effect transistor is an N-type MOS field effect transistor is used. When a direct current working point of the first MOS field effect transistor is biased to the class C, the voltage of the fourth bias voltage end may be less than a threshold voltage of the first MOS field effect transistor. When a direct current working point of the first MOS field effect transistor is biased to the class AB, the voltage of the fourth bias voltage end may be greater than a threshold voltage of the first MOS field effect transistor.

In this application, the gate bias voltage of the third MOS field effect transistor may be further adjusted by adjusting a voltage of the first bias voltage end, so that the gate-source capacitor Cgs of the third MOS field effect transistor may be adjusted by adjusting the voltage, to further compensate AM-PM, and meet a requirement of the power amplification circuit for transmitting linearity of different modulated signals.

Further, in this application, in a specific range, more effective compensation may be further performed on AM-PM by changing a size of the third MOS field effect transistor, to further improve linearity of the power amplification circuit.

According to a second aspect, the invention provides a power amplifier of claim 1, including an input matching circuit, an output matching circuit, and the power amplification circuits according to the first aspect or the implementations of the first aspect. An output signal end of the input matching circuit is connected to an input signal end of the power amplification circuit, and an input signal end of the output matching circuit is connected to an output signal end of the power amplification circuit. A problem-resolving principle of the power amplifier is similar to that of the foregoing power amplification circuit. Therefore, for implementation of the power amplifier, refer to the implementation of the foregoing power amplification circuit. Repeated parts are not described again.

In this application, the power amplification circuit compensates AM-AM and AM-PM, and good linearity can be implemented. Therefore, the power amplifier using the power amplification circuit also has good linearity.

During specific implementation, in the power amplifier, the input matching circuit may have single-ended output, or certainly may have dual-ended differential output. When the input matching circuit has single-ended output, the power amplifier includes one power amplification circuit. When the input matching circuit has dual-ended differential output, the power amplifier may include two power amplification circuits. The power amplifier provided in this embodiment of this application is described by using an example in which the input matching circuit has single-ended input and dual-ended differential output.

According to the invention the power amplifier includes a first power amplification circuit and a second power amplification circuit, the power amplifier further includs a third capacitor, where a first end of the third capacitor is connected to a drain electrode of a third MOS field effect transistor in the first power amplification circuit, and a second end of the third capacitor is connected to a drain electrode of a third MOS field effect transistor in the second power amplification circuit. A first output signal end of the input matching circuit is connected to an input signal end of the first power amplification circuit, and a second output signal end of the input matching circuit is connected to an input signal end of the second power amplification circuit. A first input signal end of the output matching circuit is connected to an output signal end of the first power amplification circuit, and a second input signal end of the output matching circuit is connected to an output signal end of the second power amplification circuit. Therefore, the first power amplification circuit and the second power amplification circuit form a full differential structure, and both the two third MOS field effect transistors are connected in series to the third capacitor, so that power supplying is not required, and power consumption of the power amplifier is not increased.

Optionally, in the power amplifier provided in this embodiment of this application, a first bias voltage end may be grounded, so that one control end can be saved, and a structure of the power amplifier is simplified.

For example, the power amplifier may further include a fourth capacitor and a fifth capacitor. The fourth capacitor is connected between the input signal end of the second power amplification circuit and the output signal end of the first power amplification circuit. The fifth capacitor is connected between the input signal end of the first power amplification circuit and the output signal end of the second power amplification circuit. The fourth capacitor and the fifth capacitor are neutralizing capacitors, and are configured to provide negative feedback for the first power amplification circuit and the second power amplification circuit, so that reverse isolation and stability of the power amplifier can be improved.

For example, to ensure an output gain of the power amplifier, the power amplifier may further include a driving-stage amplification circuit and an inter-stage matching circuit. The driving-stage amplification circuit is configured to compensate output gains of the first power amplification circuit and the second power amplification circuit. A first input signal end of the driving-stage amplification circuit is connected to the first output signal end of the input matching circuit, and a second input signal end of the driving-stage amplification circuit is connected to the second output signal end of the input matching circuit. A first output signal end of the driving-stage amplification circuit is connected to a first input signal end of the inter-stage matching circuit, and a second output signal end of the driving-stage amplification circuit is connected to a second input signal end of the inter-stage matching circuit. A first output signal end of the inter-stage matching circuit is connected to the input signal end of the first power amplification circuit, and a second output signal end of the inter-stage matching circuit is connected to the input signal end of the second power amplification circuit.

The power amplifier has a two-stage amplification structure. The first power amplification circuit and the second power amplification circuit are used as output-stage amplification circuits. The driving-stage amplification circuit is configured to compensate an output gain of the output-stage amplification circuit. Change trends of frequency response curves of the two-stage amplification circuits are roughly the same. Because the output-stage amplification circuit compensates AM-AM and AM-PM, the power amplifier can meet good linearity without reducing a gain.

In a feasible implementation, the driving-stage amplification circuit may include a fourth MOS field effect transistor, a fifth MOS field effect transistor, a sixth MOS field effect transistor, a seventh MOS field effect transistor, a third resistor, a fourth resistor, a sixth capacitor, and a seventh capacitor. A gate electrode of the fourth MOS field effect transistor is connected to a power supply voltage end, a drain electrode of the fourth MOS field effect transistor is connected to the first output signal end of the driving-stage amplification circuit, and a source electrode of the fourth MOS field effect transistor is connected to a drain electrode of the fifth MOS field effect transistor. A gate electrode of the fifth MOS field effect transistor is connected to a first end of the sixth capacitor, a source electrode of the fifth MOS field effect transistor is grounded, and a second end of the sixth capacitor is connected to the first input signal end of the driving-stage amplification circuit. A gate electrode of the sixth MOS field effect transistor is connected to the power supply voltage end, a drain electrode of the sixth MOS field effect transistor is connected to the second output signal end of the driving-stage amplification circuit, and a source electrode of the sixth MOS field effect transistor is connected to a drain electrode of the seventh MOS field effect transistor. A gate electrode of the seventh MOS field effect transistor is connected to a first end of the seventh capacitor, a source electrode of the seventh MOS field effect transistor is grounded, and a second end of the seventh capacitor is connected to the second input signal end of the driving-stage amplification circuit. The third resistor is connected between the gate electrode of the fifth MOS field effect transistor and a fifth bias voltage end, and the fourth resistor is connected between the gate electrode of the seventh MOS field effect transistor and the fifth bias voltage end. In the driving-stage amplification circuit, the fourth MOS field effect transistor, the fifth MOS field effect transistor, the sixth MOS field effect transistor, and the seventh MOS field effect transistor form a full differential cascode structure, the third resistor and the fourth resistor are bias resistors, the sixth capacitor and the seventh capacitor may isolate the gate electrode of the fifth MOS field effect transistor from the gate electrode of the seventh MOS field effect transistor, and the sixth capacitor and the seventh capacitor may further play a role of blocking a direct current and conducting an alternating current.

In this application, the fourth MOS field effect transistor, the fifth MOS field effect transistor, the sixth MOS field effect transistor, and the seventh MOS field effect transistor may all be N-type field effect transistors. During specific implementation, alternatively, the fourth MOS field effect transistor, the fifth MOS field effect transistor, the sixth MOS field effect transistor, and the seventh MOS field effect transistor may all be P-type field effect transistors.

For example, the driving-stage amplification circuit may further include an eighth capacitor and a ninth capacitor. The eighth capacitor is connected between the source electrode of the fourth MOS field effect transistor and the gate electrode of the seventh MOS field effect transistor. The ninth capacitor is connected between the source electrode of the sixth MOS field effect transistor and the gate electrode of the fifth MOS field effect transistor. The eighth capacitor and the ninth capacitor are neutralizing capacitors, and are configured to provide negative feedback for the driving-stage amplification circuit, so that stability of the driving-stage amplification circuit can be improved.

For example, the input matching circuit may include a first transformer and a fifth resistor. The fifth resistor is connected between a first input end and a second input end of the first transformer, two output ends of the first transformer are respectively the first output signal end and the second output signal end of the input matching circuit, one end of the fifth resistor is connected to the input signal end of the input matching circuit, and the other end of the fifth resistor is grounded. In the input matching circuit, in addition to voltage transformation, the first transformer may further implement transformation from single-ended input to differential output.

For example, the inter-stage matching circuit may include a second transformer and a tenth capacitor. The tenth capacitor is connected between a first input end and a second input end of the second transformer, a third input end of the second transformer is connected to the power supply voltage end, two output ends of the second transformer are respectively the first output signal end and the second output signal end of the inter-stage matching circuit, and the first input end and the second input end of the second transformer are respectively the first input signal end and the second input signal end of the inter-stage matching circuit.

For example, the output matching circuit may include a third transformer, an eleventh capacitor, and a sixth resistor. Both the sixth resistor and the eleventh capacitor are connected between two output ends of the third transformer, a first input end and a second input end of the third transformer are respectively the first input signal end and the second input signal end of the output matching circuit, a third input end of the third transformer is connected to the power supply voltage end, one end of the sixth resistor is connected to the output signal end of the output matching circuit, and the other end of the sixth resistor is grounded.

According to a third aspect, an embodiment of this application further provides a transmitter of claim 11, including a circuit board and the power amplifier according to the second aspect or the implementations of the second aspect that is electrically connected to the circuit board. Because a problem-resolving principle of the transmitter is similar to that of the foregoing power amplifier, for implementation of the transmitter, refer to the implementation of the foregoing power amplifier. Repeated parts are not described again.

For technical effects that can be achieved in the third aspect, refer to the descriptions of technical effects that can be achieved in any possible design of the second aspect. Details are not described herein again.

## BRIEF DESCRIPTION OF DRAWINGS

FIG. 1 is a schematic diagram of a structure of a power amplification circuit used in an embodiment of this application;
FIG. 2 is a schematic diagram of a structure of another power amplification circuit used in an embodiment of this application;
FIG. 3 is a schematic diagram of a structure of another power amplification circuit used in an embodiment of this application;
FIG. 4 is a schematic diagram of a structure of a power amplifier according to an embodiment helpful for understanding this application but not covered by the claims;
FIG. 5 is a schematic diagram of a structure of a power amplifier according to an embodiment of this application;
FIG. 6 is a schematic diagram of a structure of another power amplifier according to an embodiment of this application;
FIG. 7 is a schematic diagram of a structure of another power amplifier according to an embodiment of this application;
FIG. 8 is a schematic diagram of a structure of another power amplifier according to an embodiment of this application;
FIG. 9 is a schematic diagram of a structure of a comparison circuit without a compensation unit in the power amplifier shown in FIG. 6;
FIG. 10a shows a curve of a change trend of an output voltage phase of a power amplification circuit with an input power when the power amplifier shown in FIG. 9 does not include a compensation unit;
FIG. 10b shows a curve of a change trend of an output voltage phase of an output matching circuit of the power amplifier shown in FIG. 6 with an input power;
FIG. 10c shows a curve of a change trend of an output voltage phase of a compensation unit in the power amplifier shown in FIG. 6 with an input power;
FIG. 11 is a schematic diagram of a structure of a comparison circuit without a compensation unit in the power amplifier shown in FIG. 8;
FIG. 12a is a comparison diagram of a change trend of an output voltage phase with an input power when an input signal is at 5.5 GHz;

FIG. 12b is a comparison diagram of a change trend of an output voltage phase with an input power when an input signal is at 5.6 GHz;
FIG. 12c is a comparison diagram of a change trend of an output voltage phase with an input power when an input signal is at 5.7 GHz;
FIG. 12d is a comparison diagram of a change trend of an output voltage phase with an input power when an input signal is at 5.8 GHz;
FIG. 13 is a schematic diagram of a structure of another power amplifier according to an embodiment of this application; and
FIG. 14 is a diagram of emulation results of AM-PM of the power amplifier shown in FIG. 13 at different first bias voltages.

## DESCRIPTION OF EMBODIMENTS

To make the objectives, technical solutions, and advantages of this application clearer, the following further describes this application in detail with reference to the accompanying drawings. However, example implementations can be implemented in a plurality of forms, which should not be construed as being limited to the implementations described herein. In contrast, these implementations are provided to make this application more comprehensive and complete, and concepts of the example implementations are comprehensively communicated to a person skilled in the art. Same reference numerals in the figures represent same or similar structures. Therefore, repeated descriptions thereof are omitted. Words for expressing positions and directions in this application are described by using the accompanying drawings as examples. However, changes may be made as required, and all changes shall fall within the protection scope of this application. The accompanying drawings in this application are merely used to show a relative positional relationship, and do not represent a true scale.

It should be noted that specific details are set forth in the following descriptions for ease of fully understanding this application. However, this application can be implemented in a plurality of manners different from those described herein, and a person skilled in the art can perform similar promotion without departing from the connotation of this application. Therefore, this application is not limited to the following disclosed specific implementations. The following descriptions of this specification are example manners of implementing this application. However, the descriptions are intended to describe the general principle of this application, and are not intended to limit the scope of this application. The protection scope of this application shall be defined by the appended claims.

The following describes some terms in embodiments of this application, to facilitate understanding of a person skilled in the art.

1. Working statuses of a power amplifier may be classified into three types of working statuses based on different current conduction angles: a class A (first), a class B (second), and a class C (third). When the working status is the class A, the current conduction angle of the amplifier is 360°. When the working status is the class B, the current conduction angle of the amplifier is equal to 180°. When the working status is the class C, the current conduction angle of the amplifier is less than 180°. When the working status is the class AB, the current conduction angle of the amplifier is between 180° and 360°.

2. A 1dB compression point (P1dB) is a performance parameter of an output power. A higher compression point indicates a higher output power. P1dB refers to an input (or output) power point used when a gain is reduced by 1 dB compared with a very low power.

To facilitate understanding of a power amplification circuit, a power amplifier, and a transmitter provided in embodiments of this application, the following first describes a specific application scenario of the power amplification circuit, the power amplifier, and the transmitter. The technical solutions provided in embodiments of this application may be used in scenarios such as Bluetooth, Zigbee, NB-IoT, 4G LTE, and 5G NR, and may also be used in a Wi-Fi system or the like. It should be noted that the technical solutions provided in embodiments of this application are intended to include but are not limited to being used in these scenarios and any other proper scenarios. The following further describes in detail this application with reference to the accompanying drawings.

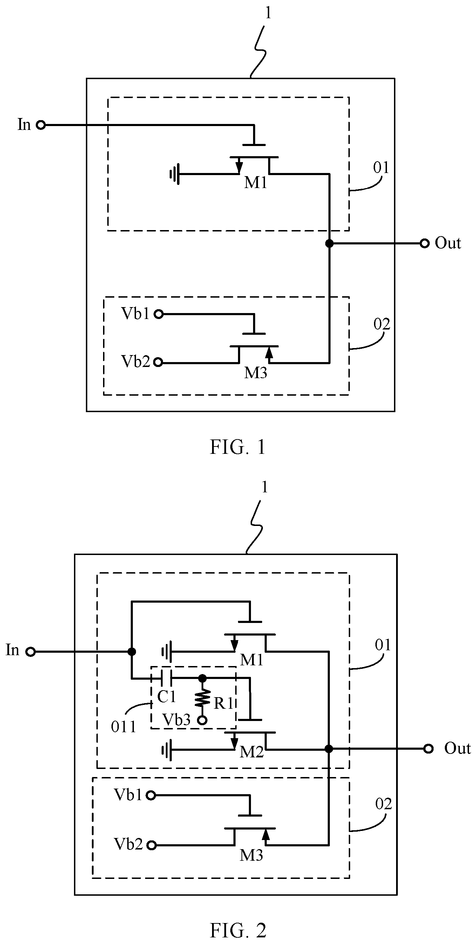

FIG. 1 is a schematic diagram of a structure of a power amplification circuit according to an embodiment of this application. The power amplification circuit 1 may include a power amplification unit 01 and a compensation unit 02. The power amplification unit 01 may include a first MOS field effect transistor M1. A gate electrode of the first MOS field effect transistor M1 is connected to an input signal end In of the power amplification circuit 1, a drain electrode of the first MOS field effect transistor M1 is connected to an output signal end Out of the power amplification circuit 1, and a source electrode of the first MOS field effect transistor M1 is grounded. The compensation unit 02 may include a third MOS field effect transistor M3. A gate electrode of the third MOS field effect transistor M3 is connected to a first bias voltage end Vb1, a source electrode of the third MOS field effect transistor M3 is connected to the output signal end Out of the power amplification circuit 1, and a drain electrode of the third MOS field effect transistor M3 is connected to a second bias voltage end Vb2. The first MOS field effect transistor M1 is an N-type MOS field effect transistor, and the third MOS field effect transistor M3 is a P-type MOS field effect transistor; or the first MOS field effect transistor M1 is a P-type MOS field effect transistor, and the third MOS field effect transistor M3 is an N-type MOS field effect transistor. FIG. 1 is illustrated by using an example in which the first MOS field effect transistor M1 is an N-type MOS field effect transistor and the third MOS field effect transistor M3 is a P-type MOS field effect transistor.

According to the power amplification circuit provided in this embodiment of this application, the power amplification unit 01 includes the first MOS field effect transistor M1, the compensation unit 02 includes the third MOS field effect transistor M3, the source electrode of the third MOS field effect transistor M3 is connected to the drain electrode of the first MOS field effect transistor M1, and a conductivity type of the third MOS field effect transistor M3 is opposite to a conductivity type of the first MOS field effect transistor M1. Therefore, a change trend of a gate-source capacitor Cgs of the third MOS field effect transistor M3 with an input voltage is opposite to a change trend of a gate-drain capacitor Cgd of the first MOS field effect transistor M1 with the input voltage, to enable the gate-drain capacitor of the first MOS field effect transistor M1 basically not to change with the input voltage after compensation, thereby compensating AM-PM and improving linearity of the power amplification circuit. In addition, a design of the power amplification circuit is simple.

In an embodiment, a voltage of the first bias voltage end may be set between 0 and Vdd, where Vdd is a power supply voltage, and the second bias voltage end may be set to a virtual ground, that is, the second bias voltage end is grounded through a capacitor.

For example, FIG. 2 is a schematic diagram of a structure of another power amplification circuit according to an embodiment of this application. In the power amplification circuit 1, the power amplification unit 01 may further include a second MOS field effect transistor M2 and a first bias sub-circuit 011. A gate electrode of the second MOS field effect transistor M2 is connected to the input signal end In of the power amplification circuit 1 through the first bias sub-circuit 011, a drain electrode of the second MOS field effect transistor M2 is connected to the output signal end Out of the power amplification circuit 1, and a source electrode of the second MOS field effect transistor M2 is grounded. The first bias sub-circuit 011 is configured to control a gate bias voltage of the second MOS field effect transistor M2. A direct current working point of the first MOS field effect transistor M1 is biased to a class C, and a direct current working point of the second MOS field effect transistor M2 is biased to a class AB; or a direct current working point of the first MOS field effect transistor M1 is biased to a class AB, and a direct current working point of the second MOS field effect transistor M2 is biased to a class C.

The first MOS field effect transistor M1 and the second MOS field effect transistor M2 have a same conductivity type, that is, both the first MOS field effect transistor M1 and the second MOS field effect transistor M2 are N-type MOS field effect transistors or P-type MOS field effect transistors.

In this application, the first MOS field effect transistor M1 and the second MOS field effect transistor M2 that are combined by using a multigate transistor (Multigate Transistor, MGTR) technology are used for the power amplification unit 01. A direct current working point of one MOS field effect transistor is biased to the class AB, so that third-order nonlinear gm" of transconductance gm of the MOS field effect transistor is negative, and a direct current working point of the other MOS field effect transistor is biased to the class C, so that third-order nonlinear gm" of transconductance gm of the other MOS field effect transistor is positive. In this way, the third-order nonlinear gm" of the transconductance gm of the two MOS field effect transistors may be counteracted, to compensate AM-AM of the power amplification circuit, and improve a P1dB compression point of the power amplification circuit.

It should be noted that in this application, a nonlinear formula of transconductance gm is shown as follows:

$$i_{DS} = I_{DC} + g_m v_{gs} + \frac{g'_m}{2!} v_{gs}^2 + \frac{g''_m}{3!} v_{gs}^3 + \cdots \quad (1)$$

For example, still with reference to FIG. 2, the first bias sub-circuit 011 may include a first capacitor C1 and a first resistor R1. A first end of the first capacitor C1 is connected to the input signal end In of the power amplification circuit 1, and a second end of the first capacitor C1 is connected to the gate electrode of the second MOS field effect transistor M2. A first end of the first resistor R1 is connected to the gate electrode of the second MOS field effect transistor M2, and a second end of the first resistor R1 is connected to a third bias voltage end Vb3. Therefore, the first resistor R1 is used to control the gate bias voltage of the second MOS field effect transistor M2, the first capacitor C1 may be used to isolate the gate electrode of the first MOS field effect transistor M1 from the gate electrode of the second MOS field effect transistor M2, and the first capacitor C1 may further play a role of blocking a direct current and conducting an alternating current.

During specific implementation, a voltage of the third bias voltage end Vb3 may be designed based on a working status of the second MOS field effect transistor M2. An example in which the second MOS field effect transistor M2 is an N-type MOS field effect transistor is used. When a direct current working point of the second MOS field effect transistor M2 is biased to the class C, the voltage of the third bias voltage end Vb3 may be less than a threshold voltage of the second MOS field effect transistor M2. When a direct current working point of the second MOS field effect transistor M2 is biased to the class AB, the voltage of the third bias voltage end Vb3 may be greater than a threshold voltage of the second MOS field effect transistor M2.

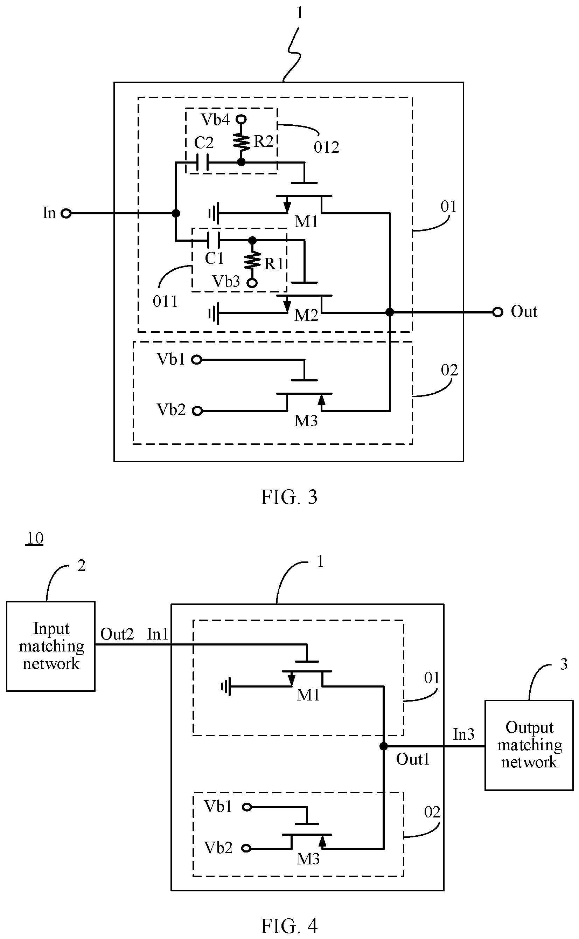

For example, FIG. 3 is a schematic diagram of a structure of another power amplification circuit according to an embodiment of this application. In the power amplification circuit 1, the power amplification unit 01 may further include a second bias sub-circuit 012 connected between the input signal end In of the power amplification circuit 1 and the gate electrode of the first MOS field effect transistor M1; and the second bias sub-circuit 012 is configured to control a gate bias voltage of the first MOS field effect transistor M1. During actual application of the power amplification circuit, when the input signal end In of the power amplification circuit 1 is connected to a transformer, the transformer is not required to control the gate bias voltage of the first MOS field effect transistor M1, and a common four-port transformer is used, to reduce design complexity.

For example, still with reference to FIG. 3, the second bias sub-circuit 012 may include a second capacitor C2 and a second resistor R2. A first end of the second capacitor C2 is connected to the input signal end In of the power amplification circuit 1, and a second end of the second capacitor C2 is connected to the gate electrode of the first MOS field effect transistor M1. A first end of the second resistor R2 is connected to the gate electrode of the first MOS field effect transistor M1, and a second end of the second resistor R2 is connected to a fourth bias voltage end Vb4. Therefore, the second resistor R2 is used to control the gate bias voltage of the first MOS field effect transistor M1, the second capacitor C2 may be used to isolate the gate electrode of the first MOS field effect transistor M1 from the gate electrode of the second MOS field effect transistor M2, and the second capacitor C2 may further play a role of blocking a direct current and conducting an alternating current.

During specific implementation, a voltage of the fourth bias voltage end Vb4 may be designed based on a working status of the first MOS field effect transistor M1. An example in which the first MOS field effect transistor M1 is an N-type MOS field effect transistor is used. When a direct current working point of the first MOS field effect transistor M1 is biased to the class C, the voltage of the fourth bias voltage end Vb4 may be less than a threshold voltage of the first MOS field effect transistor M1. When a direct current working point of the first MOS field effect transistor M1 is biased to the class AB, the voltage of the fourth bias voltage end Vb4 may be greater than a threshold voltage of the first MOS field effect transistor M1.

In this application, the gate bias voltage of the third MOS field effect transistor M3 may be further adjusted by adjusting a voltage of the first bias voltage end Vb1, so that the gate-source capacitor Cgs of the third MOS field effect transistor M3 may be adjusted by adjusting the voltage, to further compensate AM-PM, and meet a requirement of the power amplification circuit for transmitting linearity of different modulated signals.

Further, in this application, in a specific range, the AM-PM may be further compensated by changing a size of the third MOS field effect transistor M3, to further improve linearity of the power amplification circuit.

According to the foregoing power amplification circuit provided in this embodiment of this application, good linearity can be implemented by compensating AM-AM and AM-PM. In addition, because the power amplification circuit is designed simply and efficiency is not reduced, the power amplification circuit may be applied to a radio frequency power amplifier.

FIG. 4 is a schematic diagram of a structure of a power amplifier according to an embodiment helpful for understanding the invention but not covered by the claims. The power amplifier 10 includes an input matching circuit 2, an output matching circuit 3, and any one of the foregoing power amplification circuits 1 provided in embodiments of this application. An output signal end Out2 of the input matching circuit 2 is connected to an input signal end In1 of the power amplification circuit 1, and an input signal end In3 of the output matching circuit 3 is connected to an output signal end Out1 of the power amplification circuit 1. A problem-resolving principle of the power amplifier 10 is similar to that of the foregoing power amplification circuit 1. Therefore, for implementation of the power amplifier 10, refer to the implementation of the foregoing power amplification circuit 1. Repeated parts are not described again.

In this application, the power amplification circuit compensates AM-AM and AM-PM, and good linearity can be implemented. Therefore, the power amplifier using the power amplification circuit also has good linearity.

During specific implementation, in the power amplifier, the input matching circuit may have single-ended output, or certainly may have dual-ended differential output. When the input matching circuit has single-ended output, the power amplifier includes one power amplification circuit. When the input matching circuit has dual-ended differential output, the power amplifier may include two power amplification circuits. The power amplifier provided in this embodiment of this application is described by using an example in which the input matching circuit has single-ended input and dual-ended differential output.

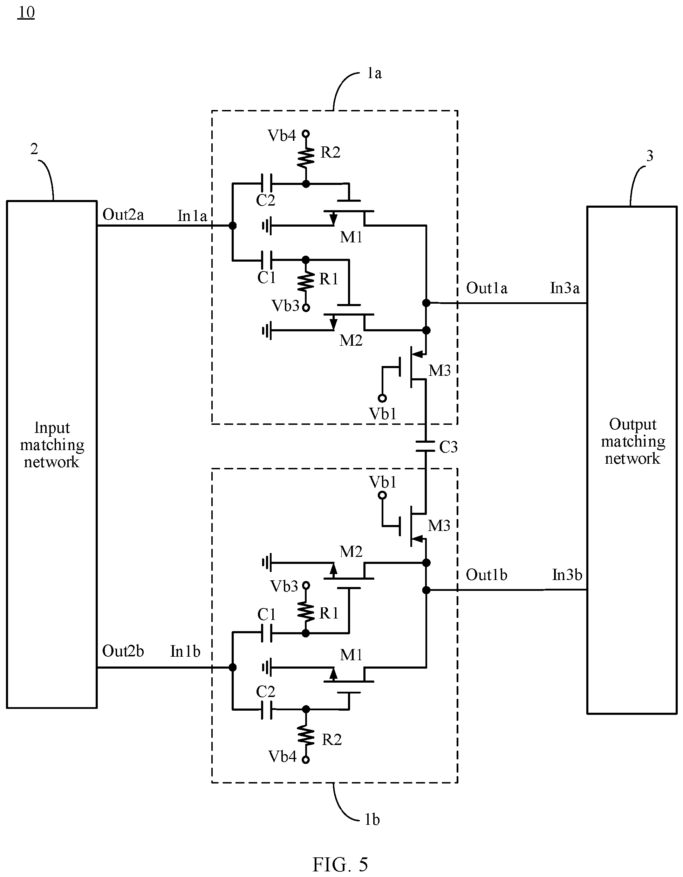

FIG. 5 is a schematic diagram of a structure of another power amplifier according to an embodiment of this application. When the power amplifier 10 includes a first power amplification circuit 1a and a second power amplification circuit 1b, the power amplifier 10 may further include a third capacitor C3, where a first end of the third capacitor C3 is connected to a drain electrode of a third MOS field effect transistor M3 in the first power amplification circuit 1a, and a second end of the third capacitor is connected to a drain electrode of a third MOS field effect transistor M3 in the second power amplification circuit 1b. A first output signal end Out2a of the input matching circuit 2 is connected to an input signal end In1a of the first power amplification circuit 1a, and a second output signal end Out2b of the input matching circuit 2 is connected to an input signal end In1b of the second power amplification circuit 1b. A first input signal end In3a of the output matching circuit 3 is connected to an output signal end Out1a of the first power amplification circuit 1a, and a second input signal end In3b of the output matching circuit 3 is connected to an output signal end Out1b of the second power amplification circuit 1b. Therefore, the first power amplification circuit 1a and the second power amplification circuit 1b form a full differential structure, and both the two third MOS field effect transistors M3 are connected in series to the third capacitor C3, so that power supplying is not required, and power consumption of the power amplifier is not increased.

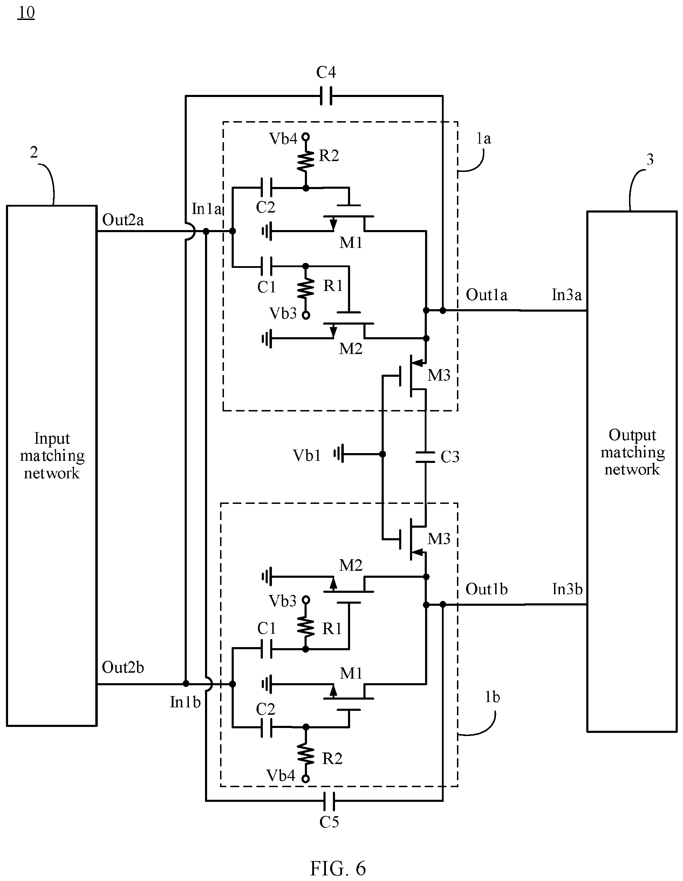

FIG. 6 is a schematic diagram of a structure of another power amplifier according to an embodiment of this application. Optionally, in the power amplifier 10 provided in this embodiment of this application, a first bias voltage end Vb1 may be grounded, so that one control end can be saved, and a structure of the power amplifier 10 is simplified.

Still with reference to FIG. 6, the power amplifier 10 may further include a fourth capacitor C4 and a fifth capacitor C5. The fourth capacitor C4 is connected between the input signal end In1b of the second power amplification circuit 1b and the output signal end Out1a of the first power amplification circuit 1a. The fifth capacitor C5 is connected between the input signal end In1a of the first power amplification circuit 1a and the output signal end Out1b of the second power amplification circuit 1b. The fourth capacitor C4 and the fifth capacitor C5 are neutralizing capacitors, and are configured to provide negative feedback for the first power amplification circuit 1a and the second power amplification circuit 1b, so that reverse isolation and stability of the power amplifier 10 can be improved.

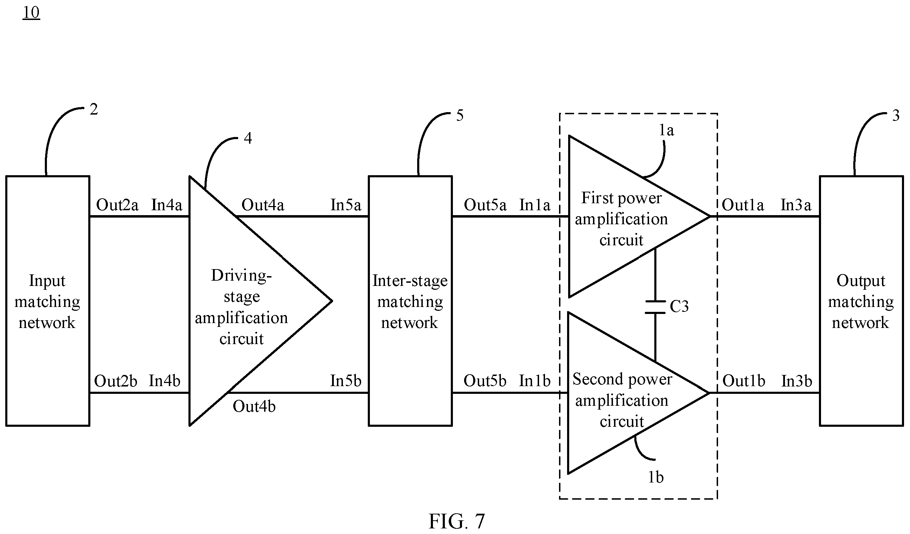

For example, FIG. 7 is a schematic diagram of a structure of another power amplifier according to an embodiment of this application. To ensure an output gain of the power amplifier, the power amplifier 10 may further include a driving-stage amplification circuit 4 and an inter-stage matching circuit 5. The driving-stage amplification circuit 4 is configured to compensate output gains of the first power amplification circuit 1a and the second power amplification circuit 1b. A first input signal end In4a of the driving-stage amplification circuit 4 is connected to the first output signal end Out2a of the input matching circuit 2, and a second input signal end In4b of the driving-stage amplification circuit 4 is connected to the second output signal end Out2b of the input matching circuit 2. A first output signal end Out4a of the driving-stage amplification circuit 4 is connected to a first input signal end In5a of the inter-stage matching circuit 5, and a second output signal end Out4b of the driving-stage amplification circuit 4 is connected to a second input signal end In5b of the inter-stage matching circuit 5. A first output signal end Out5a of the inter-stage matching circuit 5 is connected to the input signal end In1a of the first power amplification circuit 1a, and a second output signal end Out5b of the inter-stage matching circuit 5 is connected to the input signal end In1b of the second power amplification circuit 1b.

The power amplifier has a two-stage amplification structure. The first power amplification circuit 1a and the second power amplification circuit 1b are used as output-stage amplification circuits. The driving-stage amplification circuit 4 is configured to compensate an output gain of the output-stage amplification circuit. Change trends of frequency response curves of the two-stage amplification circuits are roughly the same. Because the output-stage amplification circuit compensates AM-AM and AM-PM, the power amplifier can meet good linearity without reducing a gain.

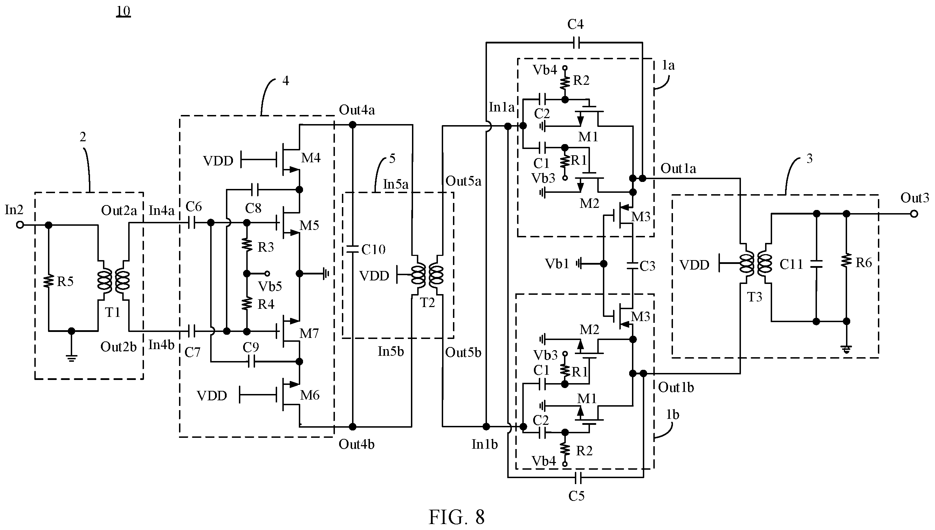

In a feasible implementation, FIG. 8 is a schematic diagram of a structure of another power amplifier according to an embodiment of this application. The driving-stage amplification circuit 4 may include a fourth MOS field effect transistor M4, a fifth MOS field effect transistor M5, a sixth MOS field effect transistor M6, a seventh MOS field effect transistor M7, a third resistor R3, a fourth resistor R4, a sixth capacitor C6, and a seventh capacitor C7. A gate electrode of the fourth MOS field effect transistor M4 is connected to a power supply voltage end VDD, a drain electrode of the fourth MOS field effect transistor M4 is connected to the first output signal end Out4a of the driving-stage amplification circuit 4, and a source electrode of the fourth MOS field effect transistor M4 is connected to a drain electrode of the fifth MOS field effect transistor M5. A gate electrode of the fifth MOS field effect transistor M5 is connected to a first end of the sixth capacitor C6, a source electrode of the fifth MOS field effect transistor M5 is grounded, and a second end of the sixth capacitor C6 is connected to the first input signal end In4a of the driving-stage amplification circuit 4. A gate electrode of the sixth MOS field effect transistor M6 is connected to the power supply voltage end VDD, a drain electrode of the sixth MOS field effect transistor M6 is connected to the second output signal end Out4b of the driving-stage amplification circuit 4, and a source electrode of the sixth MOS field effect transistor M6 is connected to a drain electrode of the seventh MOS field effect transistor M7. A gate electrode of the seventh MOS field effect transistor M7 is connected to a first end of the seventh capacitor C7, a source electrode of the seventh MOS field effect transistor M7 is grounded, and a second end of the seventh capacitor C7 is connected to the second input signal end In4b of the driving-stage amplification circuit 4. The third resistor R3 is connected between the gate electrode of the fifth MOS field effect transistor M5 and a fifth bias voltage end Vb5, and the fourth resistor R4 is connected between the gate electrode of the seventh MOS field effect transistor M7 and the fifth bias voltage end Vb5. In the driving-stage amplification circuit 4, the fourth MOS field effect transistor M4, the fifth MOS field effect transistor M5, the sixth MOS field effect transistor M6, and the seventh MOS field effect transistor M7 form a full differential cascode (Cascode) structure, the third resistor R3 and the fourth resistor R4 are bias resistors, the sixth capacitor C6 and the seventh capacitor C7 may isolate the gate electrode of the fifth MOS field effect transistor M5 from the gate electrode of the seventh MOS field effect transistor M7, and the sixth capacitor C6 and the seventh capacitor C7 may further play a role of blocking a direct current and conducting an alternating current.

During specific implementation, a voltage of the fifth bias voltage end Vb5 may be designed based on working statuses of the seventh MOS field effect transistor M7 and the fifth MOS field effect transistor M5. Generally, direct current working points of the seventh MOS field effect transistor M7 and the fifth MOS field effect transistor M5 are biased to a class AB.

In FIG. 8, an example in which the fourth MOS field effect transistor M4, the fifth MOS field effect transistor M5, the sixth MOS field effect transistor M6, and the seventh MOS field effect transistor M7 all are N-type field effect transistors is used for description. During specific implementation, alternatively, the fourth MOS field effect transistor M4, the fifth MOS field effect transistor M5, the sixth MOS field effect transistor M6, and the seventh MOS field effect transistor M7 may all be P-type field effect transistors.

For example, still with reference to FIG. 8, the driving-stage amplification circuit 4 may further include an eighth capacitor C8 and a ninth capacitor C9. The eighth capacitor C8 is connected between the source electrode of the fourth MOS field effect transistor M4 and the gate electrode of the seventh MOS field effect transistor M7. The ninth capacitor C9 is connected between the source electrode of the sixth MOS field effect transistor M6 and the gate electrode of the fifth MOS field effect transistor M5. The eighth capacitor C8 and the ninth capacitor C9 are neutralizing capacitors, and are configured to provide negative feedback for the driving-stage amplification circuit 4, so that stability of the driving-stage amplification circuit 4 can be improved.

It should be noted that the foregoing is merely an example for describing a specific structure of the driving-stage amplification circuit. During specific implementation, the specific structure of the driving-stage amplification circuit is not limited to the foregoing structure provided in embodiments of this application, and may alternatively be another structure known by a person skilled in the art. This is not limited herein.

For example, still with reference to FIG. 8, the input matching circuit 2 may include a first transformer T1 and a fifth resistor R5. The fifth resistor R5 is connected between a first input end and a second input end of the first transformer T1, two output ends of the first transformer T1 are respectively the first output signal end Out2a and the second output signal end Out2b of the input matching circuit 2, one end of the fifth resistor R5 is connected to the input signal end In2 of the input matching circuit 2, and the other end of the fifth resistor R5 is grounded. In the input matching circuit 2, in addition to voltage transformation, the first transformer T1 may further implement transformation from single-ended input to differential output.

It should be noted that the foregoing is merely an example for describing a specific structure of the input matching circuit. During specific implementation, the specific structure of the input matching circuit is not limited to the foregoing structure provided in embodiments of this application, and may alternatively be another structure known by a person skilled in the art. This is not limited herein.

For example, still with reference to FIG. 8, the inter-stage matching circuit 5 may include a second transformer T2 and a tenth capacitor C10. The tenth capacitor C10 is connected between a first input end and a second input end of the second transformer T2, a third input end of the second transformer T2 is connected to a power supply voltage end VDD, two output ends of the second transformer T2 are respectively the first output signal end Out5a and the second output signal end Out5b of the inter-stage matching circuit 5, and the first input end and the second input end of the second transformer T2 are respectively the first input signal end In5a and the second input signal end In5b of the inter-stage matching circuit 5.

It should be noted that the foregoing is merely an example for describing a specific structure of the inter-stage matching circuit. During specific implementation, the specific structure of the inter-stage matching circuit is not limited to the foregoing structure provided in embodiments of this application, and may alternatively be another structure known by a person skilled in the art. This is not limited herein.

For example, still with reference to FIG. 8, the output matching circuit 3 may include a third transformer T3, an eleventh capacitor C11, and a sixth resistor R6. Both the sixth resistor R6 and the eleventh capacitor C11 are connected between two output ends of the third transformer T3, a first input end and a second input end of the third transformer T3 are respectively the first input signal end In3a and the second input signal end In3b of the output matching circuit 3, a third input end of the third transformer T3 is connected to the power supply voltage end VDD, one end of the sixth resistor R5 is connected to the output signal end Out3 of the output matching circuit 3, and the other end of the sixth resistor R6 is grounded.

It should be noted that the foregoing is merely an example for describing a specific structure of the output matching circuit. During specific implementation, the specific structure of the output matching circuit is not limited to the foregoing structure provided in embodiments of this application, and may alternatively be another structure known by a person skilled in the art. This is not limited herein.

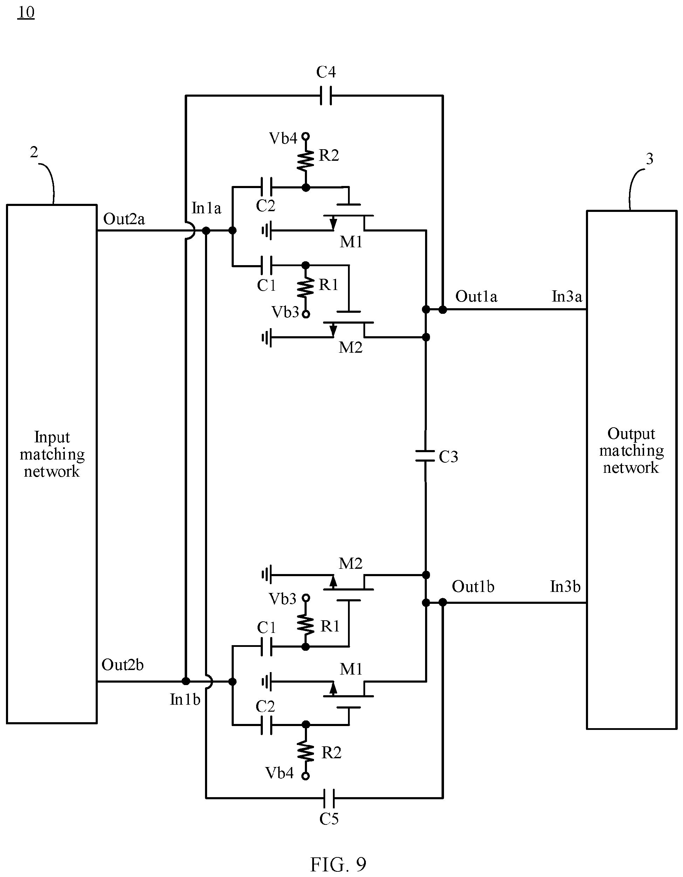

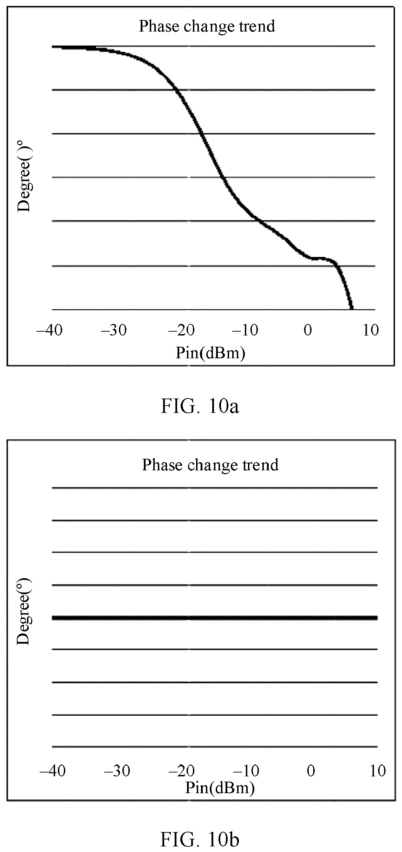

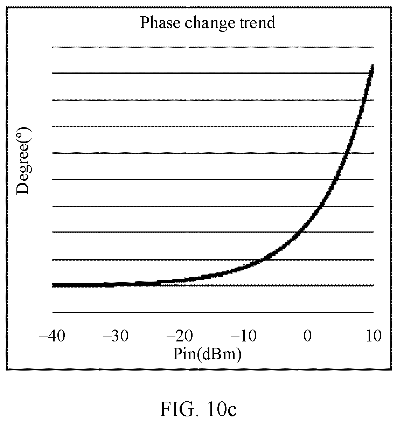

The power amplifier shown in FIG. 6 is used as an example. A comparison circuit without a compensation unit shown in FIG. 9 is established, and a change trend of an output voltage phase of the power amplifier with an input power is simulated. It can be learned from a simulation result that a change trend of an output voltage phase of an input signal in a frequency band of 5.0 GHz to 6.0 GHz is basically unchanged. Herein, 5.2 GHz is used as an example, and simulation results are shown in FIG. 10a to FIG. 10c. FIG. 10a shows a curve of a change trend of an output voltage phase of a power amplification circuit with an input power when the power amplifier shown in FIG. 9 does not include a compensation unit. FIG. 10b shows a curve of a change trend of an output voltage phase of an output matching circuit of the power amplifier shown in FIG. 6 with an input power. FIG. 10c shows a curve of a change trend of an output voltage phase of a compensation unit in the power amplifier shown in FIG. 6 with an input power. It can be learned from the simulation results that, the change trend of the output voltage phase of the compensation unit with the input power is opposite to the change trend of the output voltage phase of the power amplification circuit that does not include the compensation unit with the input power. Therefore, the change trend of the output voltage phase of the power amplification circuit with the input power after compensation performed by the compensation unit is basically unchanged. Therefore, it can be verified from the simulation results that the power amplification circuit provided in embodiments of this application can effectively compensate a phase, improve nonlinearity, and have a simple structure. In addition, AM-AM is basically not affected when AM-PM is compensated.

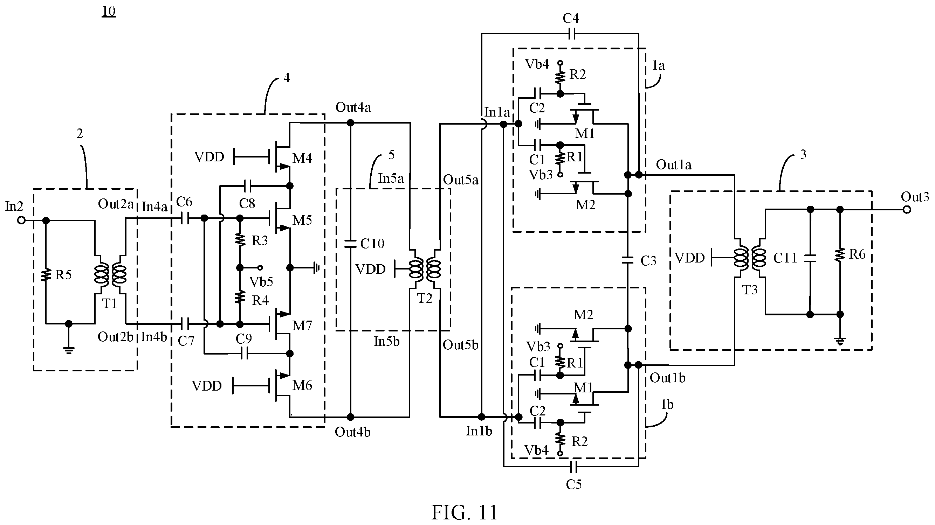

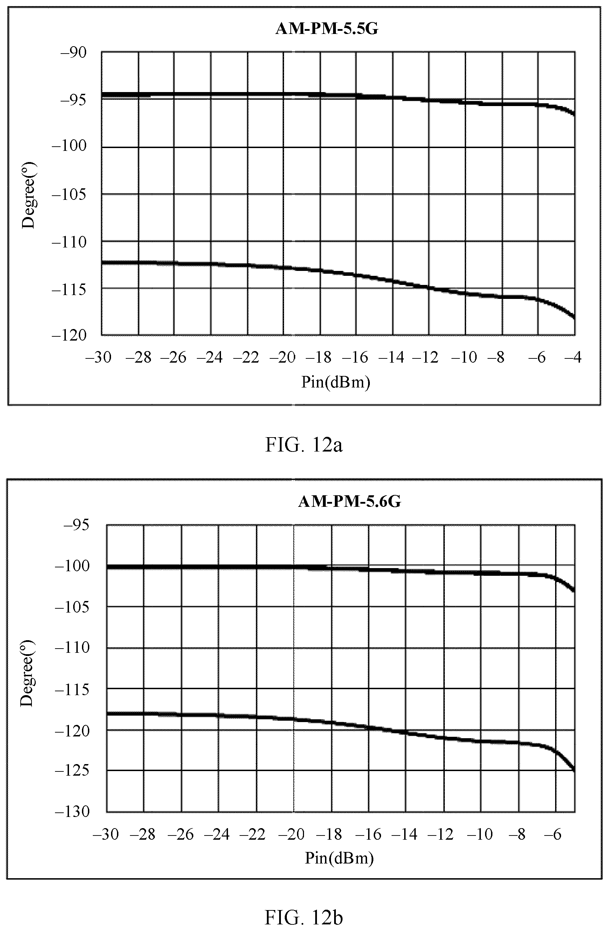

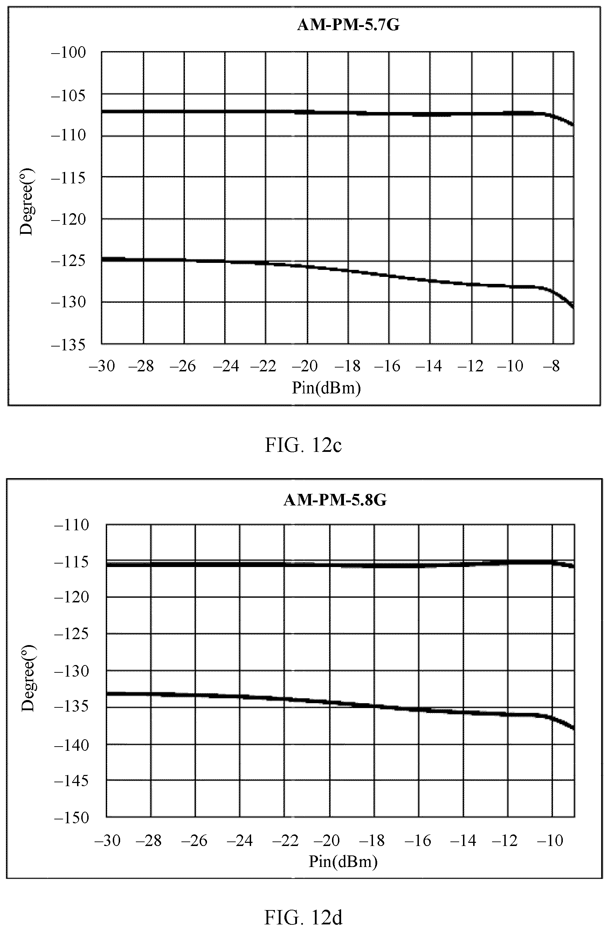

To further verify, in a simulation manner, the power amplification circuit provided in embodiments of this application, the amplifier shown in FIG. 8 is used as an example. A comparison circuit without a compensation unit shown in FIG. 11 is established. Simulation results are shown in FIG. 12a to FIG. 12d. It can be learned from comparison results that, in a frequency range of 5.5 GHz to 5.8 GHz, an AM-PM value obtained after the compensation unit is added is less than 1°, and is far less than 7° before compensation.

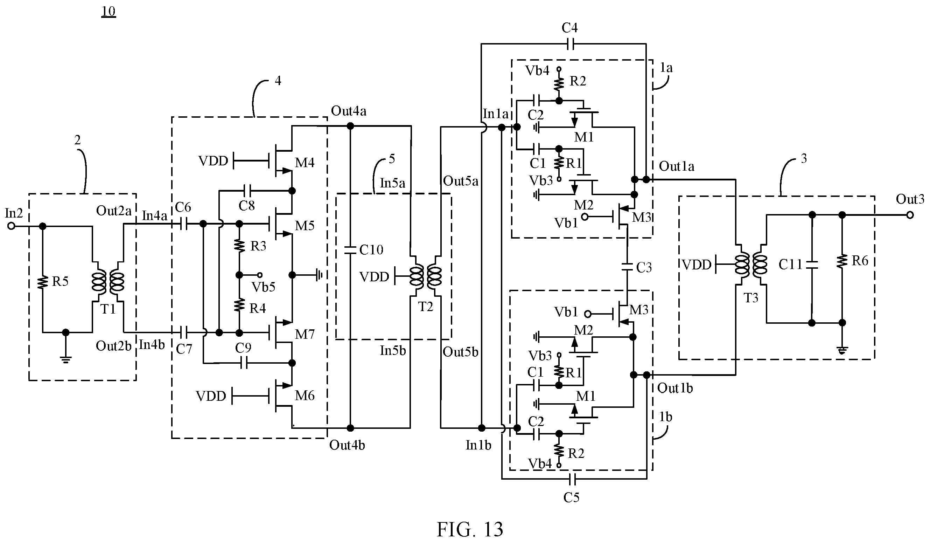

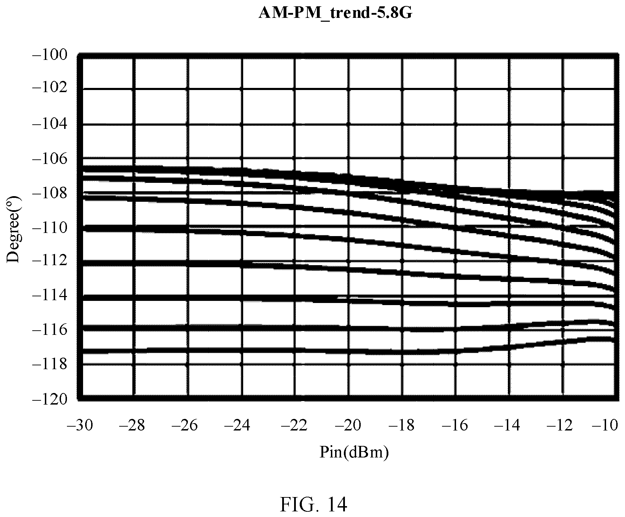

Further, when first bias voltage ends of a first power amplification circuit and a second power amplification circuit are adjustable voltage end, a power amplifier shown in FIG. 13 is used as an example, and at different voltages of the first bias voltage end Vb1, a simulation result of AM-PM is shown in FIG. 14. It can be verified from the result in the figure that a gate bias voltage of a third MOS field effect transistor M3 may be adjusted by adjusting the voltage of the first bias voltage end Vb1. In this way, a gate-source Cgs capacitor of the third MOS field effect transistor M3 can be adjusted, to achieve optimal setting of AM-PM and meet a requirement for transmitting linearity of different modulated signals.

Embodiments of this application further provide a transmitter, including a circuit board and the power amplifier that is electrically connected to the circuit board. Because a problem-resolving principle of the transmitter is similar to that of the foregoing power amplifier, for implementation of the transmitter, refer to the implementation of the foregoing power amplifier. Repeated parts are not described again.

Clearly, a person skilled in the art can make various modifications and variations to this application without departing from the scope of this application. The scope of protection defined by the following claims.

**Claims**

1. A power amplifier, comprising an input matching circuit (2), an output matching circuit (3), a first power amplification circuit (1a) and a second power amplification circuit (1b), wherein the first power amplification circuit (1a) and the second power amplification circuit (1b) are both power amplification circuits (1, 1a; 1b), each comprising a power amplification unit (01) and a compensation unit (02), wherein

the power amplification unit (01) comprises a first metal oxide semiconductor, MOS, field effect transistor, wherein a gate electrode of the first MOS field effect transistor is connected to an input signal end of the power amplification circuit (1), a drain electrode of the first MOS field effect transistor is connected to an output signal end of the power amplification circuit (1), and a source electrode of the first MOS field effect transistor is grounded;
the compensation unit (02) comprises a third MOS field effect transistor, wherein a gate electrode of the third MOS field effect transistor is connected to a first bias voltage end, a source electrode of the third MOS field effect transistor is connected to the output signal end of the power amplification circuit (1), and a drain electrode of the third MOS field effect transistor is connected to a second bias voltage end; and
the first MOS field effect transistor is an N-type MOS field effect transistor, and the third MOS field effect transistor is a P-type MOS field effect transistor; or the first MOS field effect transistor is a P-type MOS field effect transistor, and the third MOS field effect transistor is an N-type MOS field effect transistor;
wherein the power amplifier further comprises a third capacitor, wherein a first end of the third capacitor is connected to the drain electrode of the third MOS field effect transistor in the first power amplification circuit (1a), and a second end of the third capacitor is connected to the drain electrode of the third MOS field effect transistor in the second power amplification circuit (1b); and
an output signal end of the input matching circuit (2) is separately connected to the input signal end of the first power amplification circuit (1a) and the input signal end of the second power amplification circuit (1b), and an input signal end of the output matching circuit (3) is separately connected to the output signal end of the first power amplification circuit (1a) and the output signal end of the second power amplification circuit (1b).

2. The power amplification according to claim 1, wherein the power amplification unit (01) further comprises a second MOS field effect transistor and a first bias sub-circuit (011);

a gate electrode of the second MOS field effect transistor is connected to the input signal end of the power amplification circuit (1) through the first bias sub-circuit (011), a drain electrode of the second MOS field effect transistor is connected to the output signal end of the power amplification circuit (1), and a source electrode of the second MOS field effect transistor is grounded;
the first bias sub-circuit (011) is configured to control a gate bias voltage of the second MOS field effect transistor; and
a direct current working point of the first MOS field effect transistor is biased to a class C, and a direct current working point of the second MOS field effect transistor is biased to a class AB; or a direct current working point of the first MOS field effect transistor is biased to a class AB, and a direct current working point of the second MOS field effect transistor is biased to a class C.

3. The power amplification according to claim 2. wherein the first bias sub-circuit (011) comprises a first capacitor and a first resistor;

a first end of the first capacitor is connected to the input signal end of the power amplification circuit (1), and a second end of the first capacitor is connected to the gate electrode of the second MOS field effect transistor; and
a first end of the first resistor is connected to the gate electrode of the second MOS field effect transistor, and a second end of the first resistor is connected to a third bias voltage end.

4. The power amplification according to claim 2 or 3, wherein the power amplification unit (01) further comprises a second bias sub-circuit (012) connected between the input signal end of the power amplification circuit (1) and the gate electrode of the first MOS field effect transistor; and
the second bias sub-circuit (012) is configured to control a gate bias voltage of the first MOS field effect transistor.

5. The power amplification according to claim 4, wherein the second bias sub-circuit (012) comprises a second capacitor and a second resistor;

a first end of the second capacitor is connected to the input signal end of the power amplification circuit (1), and a second end of the second capacitor is connected to the gate electrode of the first MOS field effect transistor; and a first end of the second resistor is connected to the gate electrode of the first MOS field effect transistor, and a second end of the second resistor is connected to a fourth bias voltage end.

6. The power amplifier according to any one of the previous claims, wherein a first bias voltage end is grounded.

7. The power amplifier according to any one of the previous claims, wherein the power amplifier further comprises a fourth capacitor and a fifth capacitor;

the fourth capacitor is connected between the output signal end of the first power amplification circuit (1a) and the input signal end of the second power amplification circuit (1b); and the fifth capacitor is connected between the output signal end of the second power amplification circuit (1b) and the input signal end of the first power amplification circuit (1a).

8. The power amplifier according to any one of any one of the previous claims, further comprising a driving-stage amplification circuit (4) and an inter-stage matching circuit (5), wherein

the driving-stage amplification circuit (4) is configured to compensate output gains of the first power amplification circuit (1a) and the second power amplification circuit (1b); an input signal end of the driving-stage amplification circuit (4) is connected to the output signal end of the input matching circuit (2), and an output signal end of the driving-stage amplification circuit (4) is connected to an input signal end of the inter-stage matching circuit (5); and an output signal end of the inter-stage matching circuit (5) is separately connected to the input signal end of the first power amplification circuit (1a) and the input signal end of the second power amplification circuit (1b).

9. The power amplifier according to claim 8, wherein the driving-stage amplification circuit (4) comprises a fourth MOS field effect transistor, a fifth MOS field effect transistor, a sixth MOS field effect transistor, a seventh MOS field effect transistor, a third resistor, a fourth resistor, a sixth capacitor, and a seventh capacitor;

a gate electrode of the fourth MOS field effect transistor is connected to a power supply voltage end, a drain electrode of the fourth MOS field effect transistor is connected to a first output signal end of the driving-stage amplification circuit (4), and a source electrode of the fourth MOS field effect transistor is connected to a drain electrode of the fifth MOS field effect transistor; a gate electrode of the fifth MOS field effect transistor is connected to a first end of the sixth capacitor, a source electrode of the fifth MOS field effect transistor is grounded, and a second end of the sixth capacitor is connected to a first input signal end of the driving-stage amplification circuit (4); a gate electrode of the sixth MOS field effect transistor is connected to the power supply voltage end, a drain electrode of the sixth MOS field effect transistor is connected to a second output signal end of the driving-stage amplification circuit (4), and a source electrode of the sixth MOS field effect transistor is connected to a drain electrode of the seventh MOS field effect transistor; a gate electrode of the seventh MOS field effect transistor is connected to a first end of the seventh capacitor, a source electrode of the seventh MOS field effect transistor is grounded, and a second end of the seventh capacitor is connected to a second input signal end of the driving-stage amplification circuit (4); and the third resistor is connected between the gate electrode of the fifth MOS field effect transistor and a fifth bias voltage end, and the fourth resistor is connected between the gate electrode of the seventh MOS field effect transistor and the fifth bias voltage end.

10. The power amplifier according to claim 9, wherein the driving-stage amplification circuit (4) further comprises an eighth capacitor and a ninth capacitor;

the eighth capacitor is connected between the source electrode of the fourth MOS field effect transistor and the gate electrode of the seventh MOS field effect transistor; and the ninth capacitor is connected between the source electrode of the sixth MOS field effect transistor and the gate electrode of the fifth MOS field effect transistor.

11. A transmitter, comprising a circuit board and the power amplifier according to any one of any one of the previous claims that is electrically connected to the circuit board.

## Patentansprüche

1. Leistungsverstärker, umfassend eine Eingangsanpassungsschaltung (2), eine Ausgangsanpassungsschaltung (3), eine erste Leistungsverstärkungsschaltung (1a) und eine zweite Leistungsverstärkungsschaltung (1b), wobei die erste Leistungsverstärkungsschaltung (1a) und die zweite Leistungsverstärkungsschaltung (1b) beide Leistungsverstärkungsschaltungen (1, 1a; 1b) sind, die jeweils eine Leistungsverstärkungseinheit (01) und eine Kompensationseinheit (02) umfassen, wobei

   die Leistungsverstärkungseinheit (01) einen ersten Metalloxid-Halbleiter-Feldeffekttransistor, MOS-Feldeffekttransistor, umfasst, wobei eine Gate-Elektrode des ersten MOS-Feldeffekttransistors mit einem Eingangssignalende der Leistungsverstärkungsschaltung (1) verbunden ist, eine Drain-Elektrode des ersten MOS-Feldeffekttransistors mit einem Ausgangssignalende der Leistungsverstärkungsschaltung (1) verbunden ist und eine Source-Elektrode des ersten MOS-Feldeffekttransistors geerdet ist;
   die Kompensationseinheit (02) einen dritten MOS-Feldeffekttransistor umfasst, wobei eine Gate-Elektrode des dritten MOS-Feldeffekttransistors mit einem ersten Vorspannungsende verbunden ist, eine Source-Elektrode des dritten MOS-Feldeffekttransistors mit dem Ausgangssignalende der Leistungsverstärkungsschaltung (1) verbunden ist und eine Drain-Elektrode des dritten MOS-Feldeffekttransistors mit einem zweiten Vorspannungsende verbunden ist; und
   der erste MOS-Feldeffekttransistor ein MOS-Feldeffekttransistor des N-Typs ist und der dritte MOS-Feldeffekttransistor ein MOS-Feldeffekttransistor des P-Typs ist; oder der erste MOS-Feldeffekttransistor ein MOS-Feldeffekttransistor des P-Typs ist und der dritte MOS-Feldeffekttransistor ein MOS-Feldeffekttransistor des N-Typs ist;
   wobei der Leistungsverstärker ferner einen dritten Kondensator umfasst, wobei ein erstes Ende des dritten Kondensators mit der Drain-Elektrode des dritten MOS-Feldeffekttransistors in der ersten Leistungsverstärkungsschaltung (1a) verbunden ist und ein zweites Ende des dritten Kondensators mit der Drain-Elektrode des dritten MOS-Feldeffekttransistors in der zweiten Leistungsverstärkungsschaltung (1b) verbunden ist; und
   ein Ausgangssignalende der Eingangsanpassungsschaltung (2) separat mit dem Eingangssignalende der ersten Leistungsverstärkungsschaltung (1a) und dem Eingangssignalende der zweiten Leistungsverstärkungsschaltung (1b) verbunden ist, und ein Eingangssignalende der Ausgangsanpassungsschaltung (3) separat mit dem Ausgangssignalende der ersten Leistungsverstärkungsschaltung (1a) und dem Ausgangssignalende der zweiten Leistungsverstärkungsschaltung (1b) verbunden ist.

2. Leistungsverstärkung nach Anspruch 1, wobei die Leistungsverstärkungseinheit (01) ferner einen zweiten MOS-Feldeffekttransistor und eine erste Vorspannungs-Teilschaltung (011) umfasst;

   eine Gate-Elektrode des zweiten MOS-Feldeffekttransistors über die erste Vorspannungs-Teilschaltung (011) mit dem Eingangssignalende der Leistungsverstärkungsschaltung (1) verbunden ist, eine Drain-Elektrode des zweiten MOS-Feldeffekttransistors mit dem Ausgangssignalende der Leistungsverstärkungsschaltung (1) verbunden ist und eine Source-Elektrode des zweiten MOS-Feldeffekttransistors geerdet ist;
   die erste Vorspannungs-Teilschaltung (011) dazu konfiguriert ist, eine Gate-Vorspannung des zweiten MOS-Feldeffekttransistors zu steuern; und
   ein Gleichstrom-Betriebspunkt des ersten MOS-Feldeffekttransistors auf eine Klasse C vorgespannt ist, und ein Gleichstrom-Betriebspunkt des zweiten MOS-Feldeffekttransistors auf eine Klasse AB vorgespannt ist; oder ein Gleichstrom-Betriebspunkt des ersten MOS-Feldeffekttransistors auf eine Klasse AB vorgespannt ist, und ein Gleichstrom-Betriebspunkt des zweiten MOS-Feldeffekttransistors auf eine Klasse C vorgespannt ist.

3. Leistungsverstärkung nach Anspruch 2, wobei die erste Vorspannungs-Teilschaltung (011) einen ersten Kondensator und einen ersten Widerstand umfasst;

   ein erstes Ende des ersten Kondensators mit dem Eingangssignalende der Leistungsverstärkungsschaltung (1) verbunden ist, und ein zweites Ende des ersten Kondensators mit der Gate-Elektrode des zweiten MOS-Feldeffekttransistors verbunden ist; und
   ein erstes Ende des ersten Widerstands mit der Gate-Elektrode des zweiten MOS-Feldeffekttransistors verbunden ist, und ein zweites Ende des ersten Widerstands mit einem dritten Vorspannungsende verbunden ist.

4. Leistungsverstärkung nach Anspruch 2 oder 3, wobei die Leistungsverstärkungseinheit (01) ferner eine zweite Vorspannungs-Teilschaltung (012) umfasst, die zwischen dem Eingangssignalende der Leistungsverstärkungsschaltung (1) und der Gate-Elektrode des ersten MOS-Feldeffekttransistors verbunden ist; und

die zweite Vorspannungs-Teilschaltung (012) dazu konfiguriert ist, eine Gate-Vorspannung des ersten MOS-Feldeffekttransistors zu steuern.

5. Leistungsverstärkung nach Anspruch 4, wobei die zweite Vorspannungs-Teilschaltung (012) einen zweiten Kondensator und einen zweiten Widerstand umfasst;

ein erstes Ende des zweiten Kondensators mit dem Eingangssignalende der Leistungsverstärkungsschaltung (1) verbunden ist, und ein zweites Ende des zweiten Kondensators mit der Gate-Elektrode des ersten MOS-Feldeffekttransistors verbunden ist; und
ein erstes Ende des zweiten Widerstands mit der Gate-Elektrode des ersten MOS-Feldeffekttransistors verbunden ist, und ein zweites Ende des zweiten Widerstands mit einem vierten Vorspannungsende verbunden ist.

6. Leistungsverstärker nach einem der vorhergehenden Ansprüche, wobei ein erstes Vorspannungsende geerdet ist.

7. Leistungsverstärker nach einem der vorhergehenden Ansprüche, wobei der Leistungsverstärker ferner einen vierten Kondensator und einen fünften Kondensator umfasst;

der vierte Kondensator zwischen dem Ausgangssignalende der ersten Leistungsverstärkungsschaltung (1a) und dem Eingangssignalende der zweiten Leistungsverstärkungsschaltung (1b) verbunden ist; und
der fünfte Kondensator zwischen dem Ausgangssignalende der zweiten Leistungsverstärkungsschaltung (1b) und dem Eingangssignalende der ersten Leistungsverstärkungsschaltung (1a) verbunden ist.

8. Leistungsverstärker nach einem der vorhergehenden Ansprüche, ferner umfassend eine Treiberstufen-Verstärkungsschaltung (4) und eine Zwischenstufen-Anpassungsschaltung (5), wobei

die Treiberstufen-Verstärkungsschaltung (4) dazu konfiguriert ist, Ausgangsverstärkungen der ersten Leistungsverstärkungsschaltung (1a) und der zweiten Leistungsverstärkungsschaltung (1b) zu kompensieren;
ein Eingangssignalende der Treiberstufen-Verstärkungsschaltung (4) mit dem Ausgangssignalende der Eingangsanpassungsschaltung (2) verbunden ist, und ein Ausgangssignalende der Treiberstufen-Verstärkungsschaltung (4) mit einem Eingangssignalende der Zwischenstufen-Anpassungsschaltung (5) verbunden ist; und
ein Ausgangssignalende der Zwischenstufen-Anpassungsschaltung (5) separat mit dem Eingangssignalende der ersten Leistungsverstärkungsschaltung (1a) und dem Eingangssignalende der zweiten Leistungsverstärkungsschaltung (1b) verbunden ist.

9. Leistungsverstärker nach Anspruch 8, wobei die Treiberstufen-Verstärkungsschaltung (4) einen vierten MOS-Feldeffekttransistor, einen fünften MOS-Feldeffekttransistor, einen sechsten MOS-Feldeffekttransistor, einen siebten MOS-Feldeffekttransistor, einen dritten Widerstand, einen vierten Widerstand, einen sechsten Kondensator und einen siebten Kondensator umfasst;

eine Gate-Elektrode des vierten MOS-Feldeffekttransistors mit einem Ende der Stromversorgungsspannung verbunden ist, eine Drain-Elektrode des vierten MOS-Feldeffekttransistors mit einem ersten Ausgangssignalende der Treiberstufen-Verstärkungsschaltung (4) verbunden ist und eine Source-Elektrode des vierten MOS-Feldeffekttransistors mit einer Drain-Elektrode des fünften MOS-Feldeffekttransistors verbunden ist;
eine Gate-Elektrode des fünften MOS-Feldeffekttransistors mit einem ersten Ende des sechsten Kondensators verbunden ist, eine Source-Elektrode des fünften MOS-Feldeffekttransistors geerdet ist und ein zweites Ende des sechsten Kondensators mit einem ersten Eingangssignalende der Treiberstufen-Verstärkungsschaltung (4) verbunden ist;
eine Gate-Elektrode des sechsten MOS-Feldeffekttransistors mit dem Ende der Stromversorgungsspannung verbunden ist, eine Drain-Elektrode des sechsten MOS-Feldeffekttransistors mit einem zweiten Ausgangssignalende der Treiberstufen-Verstärkungsschaltung (4) verbunden ist und eine Source-Elektrode des sechsten MOS-Feldeffekttransistors mit einer Drain-Elektrode des siebten MOS-Feldeffekttransistors verbunden ist;
eine Gate-Elektrode des siebten MOS-Feldeffekttransistors mit einem ersten Ende des siebten Kondensators verbunden ist, eine Source-Elektrode des siebten MOS-Feldeffekttransistors geerdet ist und ein zweites Ende des siebten Kondensators mit einem zweiten Eingangssignalende der Treiberstufen-Verstärkungsschaltung (4) verbunden ist; und
der dritte Widerstand zwischen der Gate-Elektrode des fünften MOS-Feldeffekttransistors und einem fünften Vorspannungsende verbunden ist, und der vierte Widerstand zwischen der Gate-Elektrode des siebten MOS-Feldeffekttransistors und dem fünften Vorspannungsende verbunden ist.

10. Leistungsverstärker nach Anspruch 9, wobei die Treiberstufen-Verstärkungsschaltung (4) ferner einen achten Kondensator und einen neunten Kondensator umfasst;

der achte Kondensator zwischen der Source-Elektrode des vierten MOS-Feldeffekttransistors und der Gate-Elektrode des siebten MOS-Feldeffekttransistors verbunden ist; und der neunte Kondensator zwischen der Source-Elektrode des sechsten MOS-Feldeffekttransistors und der Gate-Elektrode des fünften MOS-Feldeffekttransistors verbunden ist.

11. Sender, umfassend eine Leiterplatte und den Leistungsverstärker nach einem der vorhergehenden Ansprüche, der elektrisch mit der Leiterplatte verbunden ist.

## Revendications

1. Amplificateur de puissance comprenant un circuit d'adaptation d'entrée (2), un circuit d'adaptation de sortie (3), un premier circuit d'amplification de puissance (1a) et un second circuit d'amplification de puissance (1b), dans lequel le premier circuit d'amplification de puissance (1a) et le second circuit d'amplification de puissance (1b) sont tous deux des circuits d'amplification de puissance (1, 1a ; 1b), chacun comprenant une unité d'amplification de puissance (01) et une unité de compensation (02), dans lequel

l'unité d'amplification de puissance (01) comprend un premier transistor à effet de champ de semi-conducteur d'oxyde de métal, MOS, dans lequel une électrode de grille du premier transistor à effet de champ MOS est connectée à une extrémité de signal d'entrée du circuit d'amplification de puissance (1), une électrode de drain du premier transistor à effet de champ MOS est connectée à une extrémité de signal de sortie du circuit d'amplification de puissance (1), et une électrode de source du premier transistor à effet de champ MOS est mise à la terre ;
l'unité de compensation (02) comprend un troisième transistor à effet de champ MOS, dans lequel une électrode de grille du troisième transistor à effet de champ MOS est connectée à une première extrémité de tension de polarisation, une électrode de source du troisième transistor à effet de champ MOS est connectée à l'extrémité de signal de sortie du circuit d'amplification de puissance (1), et une électrode de drain du troisième transistor à effet de champ MOS est connectée à une deuxième extrémité de tension de polarisation ; et
le premier transistor à effet de champ MOS est un transistor à effet de champ MOS de type N, et le troisième transistor à effet de champ MOS est un transistor à effet de champ MOS de type P ; ou le premier transistor à effet de champ MOS est un transistor à effet de champ MOS de type P, et le troisième transistor à effet de champ MOS est un transistor à effet de champ MOS de type N ;
dans lequel l'amplificateur de puissance comprend également un troisième condensateur, dans lequel une première extrémité du troisième condensateur est connectée à l'électrode de drain du troisième transistor à effet de champ MOS dans le premier circuit d'amplification de puissance (1a), et une seconde extrémité du troisième condensateur est connectée à l'électrode de drain du troisième transistor à effet de champ MOS dans le second circuit d'amplification de puissance (1b) ; et
une extrémité de signal de sortie du circuit d'adaptation d'entrée (2) est connectée séparément à l'extrémité de signal d'entrée du premier circuit d'amplification de puissance (1a) et à l'extrémité de signal d'entrée du second circuit d'amplification de puissance (1b), et une extrémité de signal d'entrée du circuit d'adaptation de sortie (3) est connectée séparément à l'extrémité de signal de sortie du premier circuit d'amplification de puissance (1a) et à l'extrémité de signal de sortie du second circuit d'amplification de puissance (1b).

2. Amplification de puissance selon la revendication 1, dans laquelle l'unité d'amplification de puissance (01) comprend également un deuxième transistor à effet de champ MOS et un premier sous-circuit de polarisation (011) ;

une électrode de grille du deuxième transistor à effet de champ MOS est connectée à l'extrémité du signal d'entrée du circuit d'amplification de puissance (1) par le biais du premier sous-circuit de polarisation (011), une électrode de drain du deuxième transistor à effet de champ MOS est connectée à l'extrémité du signal de sortie du circuit d'amplification de puissance (1), et une électrode de source du deuxième transistor à effet de champ MOS est mise à la terre ;
le premier sous-circuit de polarisation (011) est configuré pour réguler une tension de polarisation de grille du deuxième transistor à effet de champ MOS ; et

un point de fonctionnement en courant continu du premier transistor à effet de champ MOS est polarisé vers une classe C, et un point de fonctionnement en courant continu du deuxième transistor à effet de champ MOS est polarisé vers une classe AB ;

ou un point de fonctionnement en courant continu du premier transistor à effet de champ MOS est polarisé vers une classe AB, et un point de fonctionnement en courant continu du deuxième transistor à effet de champ MOS est polarisé vers une classe C.

3. Amplification de puissance selon la revendication 2, dans laquelle le premier sous-circuit de polarisation (011) comprend un premier condensateur et une première résistance ;

une première extrémité du premier condensateur est connectée à l'extrémité du signal d'entrée du circuit d'amplification de puissance (1), et une seconde extrémité du premier condensateur est connectée à l'électrode de grille du deuxième transistor à effet de champ MOS ; et une première extrémité de la première résistance est connectée à l'électrode de grille du deuxième transistor à effet de champ MOS, et une seconde extrémité de la première résistance est connectée à une troisième extrémité de tension de polarisation.

4. Amplification de puissance selon la revendication 2 ou 3, dans laquelle l'unité d'amplification de puissance (01) comprend également un second sous-circuit de polarisation (012) connecté entre l'extrémité de signal d'entrée du circuit d'amplification de puissance (1) et l'électrode de grille du premier transistor à effet de champ MOS ; et le second sous-circuit de polarisation (012) est configuré pour réguler une tension de polarisation de grille du premier transistor à effet de champ MOS.

5. Amplification de puissance selon la revendication 4, dans laquelle le second sous-circuit de polarisation (012) comprend un deuxième condensateur et une deuxième résistance ;

une première extrémité du deuxième condensateur est connectée à l'extrémité du signal d'entrée du circuit d'amplification de puissance (1), et une seconde extrémité du deuxième condensateur est connectée à l'électrode de grille du premier transistor à effet de champ MOS ; et une première extrémité de la deuxième résistance est connectée à l'électrode de grille du premier transistor à effet de champ MOS, et une seconde extrémité de la deuxième résistance est connectée à une quatrième extrémité de tension de polarisation.

6. Amplificateur de puissance selon l'une quelconque des revendications précédentes, dans lequel une première extrémité de tension de polarisation est mise à la terre.

7. Amplificateur de puissance selon l'une quelconque des revendications précédentes, dans lequel l'amplificateur de puissance comprend également un quatrième condensateur et un cinquième condensateur ;

le quatrième condensateur est connecté entre l'extrémité du signal de sortie du premier circuit d'amplification de puissance (1a) et l'extrémité du signal d'entrée du second circuit d'amplification de puissance (1b) ; et le cinquième condensateur est connecté entre l'extrémité du signal de sortie du second circuit d'amplification de puissance (1b) et l'extrémité du signal d'entrée du premier circuit d'amplification de puissance (1a).

8. Amplificateur de puissance selon l'une quelconque des revendications précédentes, comprenant également un circuit d'amplification d'étage de commande (4) et un circuit d'adaptation inter-étages (5), dans lequel

le circuit d'amplification d'étage de commande (4) est configuré pour compenser les gains de sortie du premier circuit d'amplification de puissance (1a) et du second circuit d'amplification de puissance (1b) ; une extrémité du signal d'entrée du circuit d'amplification d'étage de commande (4) est connectée à l'extrémité du signal de sortie du circuit d'adaptation d'entrée (2), et une extrémité du signal de sortie du circuit d'amplification d'étage de commande (4) est connectée à une extrémité du signal d'entrée du circuit d'adaptation inter-étages (5) ; et une extrémité de signal de sortie du circuit d'adaptation inter-étages (5) est connectée séparément à l'extrémité de signal d'entrée du premier circuit d'amplification de puissance (1a) et à l'extrémité de signal d'entrée du second circuit d'amplification de puissance (1b).

9. Amplificateur de puissance selon la revendication 8, dans lequel le circuit d'amplification d'étage de commande (4) comprend un quatrième transistor à effet de champ MOS, un cinquième transistor à effet de champ MOS, un sixième transistor à effet de champ MOS, un septième transistor à effet de champ MOS, une troisième résistance, une quatrième résistance, un sixième condensateur et un septième condensateur ;

une électrode de grille du quatrième transistor à effet de champ MOS est connectée à une extrémité de tension d'alimentation, une électrode de drain du quatrième transistor à effet de champ MOS est connectée à une première extrémité de signal de sortie du circuit d'amplification d'étage de commande (4), et une électrode de source du quatrième transistor à effet de champ MOS est connectée à une électrode de drain du cinquième transistor à effet de champ MOS ;

une électrode de grille du cinquième transistor à effet de champ MOS est connectée à une première extrémité du sixième condensateur, une électrode de source du cinquième transistor à effet de champ MOS est mise à la terre, et une seconde extrémité du sixième condensateur est connectée à une première extrémité de signal d'entrée du circuit d'amplification d'étage de commande (4) ;

une électrode de grille du sixième transistor à effet de champ MOS est connectée à une extrémité de tension d'alimentation, une électrode de drain du sixième transistor à effet de champ MOS est connectée à une seconde extrémité de signal de sortie du circuit d'amplification d'étage de commande (4), et une électrode de source du sixième transistor à effet de champ MOS est connectée à une électrode de drain du septième transistor à effet de champ MOS ;

une électrode de grille du septième transistor à effet de champ MOS est connectée à une première extrémité du septième condensateur, une électrode de source du septième transistor à effet de champ MOS est mise à la terre, et une seconde extrémité du septième condensateur est connectée à une seconde extrémité de signal d'entrée du circuit d'amplification d'étage de commande (4) ; et

la troisième résistance est connectée entre l'électrode de grille du cinquième transistor à effet de champ MOS et une cinquième extrémité de tension de polarisation, et la quatrième résistance est connectée entre l'électrode de grille du septième transistor à effet de champ MOS et la cinquième extrémité de tension de polarisation.

10. Amplificateur de puissance selon la revendication 9, dans lequel le circuit d'amplification de l'étage de commande (4) comprend également un huitième condensateur et un neuvième condensateur ;

le huitième condensateur est connecté entre l'électrode source du quatrième transistor à effet de champ MOS et l'électrode de grille du septième transistor à effet de champ MOS ; et le neuvième condensateur est connecté entre l'électrode source du sixième transistor à effet de champ MOS et l'électrode de grille du cinquième transistor à effet de champ MOS.

11. Émetteur, comprenant une carte de circuit imprimé et l'amplificateur de puissance selon l'une quelconque des revendications précédentes qui est connecté électriquement à la carte de circuit imprimé.

FIG. 1

FIG. 2

FIG. 3

FIG. 4

FIG. 5

FIG. 6

FIG. 7

FIG. 8

FIG. 9

FIG. 10a

FIG. 10b

FIG. 10c

FIG. 11

FIG. 12a

FIG. 12b

FIG. 12c

FIG. 12d

FIG. 13

**AM-PM_trend-5.8G**

FIG. 14

**EP 4 391 373 B1**

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 104124924 A

**Non-patent literature cited in the description**

- Linearization Techniques for CMOS Low Noise Amplifiers: A Tutorial. **HENG ZHANG et al.** IEEE TRANSACTIONS ON CIRCUITS AND SYSTEMS I: REGULAR PAPERS. IEEE, 01 January 2011, vol. 58, 22-36